**Europäisches Patentamt**

**European Patent Office**

**Office européen des brevets**

(19)

(11) Veröffentlichungsnummer: **0 071 827**
**B1**

(12) **EUROPÄISCHE PATENTSCHRIFT**

(45) Veröffentlichungstag der Patentschrift:
20.04.88

(51) Int. Cl.⁴: **H 01 L 23/48**, H 05 K 7/02

(21) Anmeldenummer: **82106593.5**

(22) Anmeldetag: **21.07.82**

(54) **Mit äusseren Anschlusselementen elektrisch verbundene elektronische Bauteile.**

(30) Priorität: **23.07.81 DE 3129134**

(43) Veröffentlichungstag der Anmeldung:
**16.02.83 Patentblatt 83/7**

(45) Bekanntmachung des Hinweises auf die Patenterteilung:
**20.04.88 Patentblatt 88/16**

(84) Benannte Vertragsstaaten:
**DE FR IT SE**

(56) Entgegenhaltungen:
**FR - A - 2 044 193**
**US - A - 3 981 076**

**IBM TECHNICAL DISCLOSURE BULLETIN, Band 10, Nr. 5, Oktober 1967, Seiten 657-658, New York, USA, L.F. MILLER et al.: "Semiconductor chip joining"**
**PATENTS ABSTRACTS OF JAPAN, Band 6, Nr. 87(E-108)(965), 25. Mai 1982**
**PATENTS ABSTRACTS OF JAPAN, Band 6, Nr. 67(E-104)(945), 28. April 1982**

(73) Patentinhaber: **Siemens Aktiengesellschaft Berlin und München, Wittelsbacherplatz 2, D-8000 München 2 (DE)**

(72) Erfinder: **Jung, Albert, Ing. grad., Birkenstrasse 49, D-8028 Taufkirchen (DE)**

EP 0 071 827 B1

## Beschreibung

Die Erfindung betrifft ein elektrisches Oberflächenwellenfilter mit einer metallischen Chipwanne als Systemträger, mit streifenförmigen, äusseren Anschlusselementen, die gegen die Chipwanne elektrisch isoliert sind, mit drahtgebondeten elektrischen Kontakten zwischen den aktiven Bereichen des Oberflächenwellenfilters und den äusseren Anschlusselementen, und mit aus thermoplastischem Material gespritztem Gehäuse- und Systemträgersockel mit Isolierplättchen zwischen den äusseren Anschlusselementen und der Chipwanne.

Bei der Herstellung von elektrischenBauteilen, insbesondere integrierten Schaltungen und OFW-Filtern, werden die aktiven Chip-Bereiche mittels Drahtbonden mit den Anschlusspunkten des Gehäuses, d.h. mit den in das Gehäuseinnere gekehrten Kontaktstellen der äusseren Anschlusselemente verbunden. Zwischen den zu verbindenden Kontaktstellen wird dabei der Draht bogenförmig verlegt. Bei Systemträgern, die bereits mit dem thermoplastischen Gehäusesockel umspritzt sind, kann es geschehen, dass, bedingt durch die beim Drahtbonden auftretende Erwärmung des Systemträgers, der Draht mit dem Systemträger bzw. mit dem Ghäusesockel verklebt und damit die notwendige bogenförmige Ausbildung des Drahtes gestört wird. In diesen Fällen erreicht der Draht nicht den erforderlichen Abstand zu anderen elektrischen Potentialen bzw. verursacht einen Kurzschluss und damit den Ausfall des betroffenen elektronischen Bauteiles.

An dieser Stelle sei noch erwähnt, dass durch FR-A-2 044 193 die Verwendung eines aus elektrisch nichtleitendem Material, nämlich Glas, bestehenden Steges in einem elektronischen Bauelement, d.h. einem Halbleiterchip bekannt ist. Bei diesem Bauelement liegt der Steg zwischen den Kontaktstellen elektrisch leitender Bänder, um Kurzschlüsse zwischen den Bändern und dem Halbleiterchip zu vermeiden.

Das vorstehend erwähnte, gerätebedingte Problem kann durch verbesserten maschinellen Ablauf des Bondvorganges günstig beeinflusst werden. Die vorliegende Erfindung hat sich die Aufgabe gestellt, eine geräteunabhängige Lösung für dieses Problem zu schaffen.

Zur Lösung dieser Aufgabe schlägt die Erfindung bei einem elektrischen Oberflächenwellenfilter der eingangs erwähnten Art vor, dass die Isolierplättchen einstückig an dem Gehäuse- und Systemträgersockel angeformt sind und auf ihren zu den Bonddrähten gekehrten Seitenflächen einstückig angeformte Stege aufweisen, wobei der Gehäuse- und Systemträgersockel, die Isolierplättchen und die Stege aus thermoplastischem Material bestehen.

Die Erfindung wird nachstehend anhand eines Ausführungsbeispieles näher erläutert. Es zeigt:

Fig. 1 eine Draufsicht auf ein OFW-Filter in schematischer Darstellung, wobei das Gehäuse strichpunktiert angedeutet ist,

Fig. 2 das OFW-Filter nach Fig. 1 in Seitenansicht,

Fig. 3 das in Fig. 2 mit A bezeichnete Detail im vergrösserten Massstab und in gebrochener Darstellung.

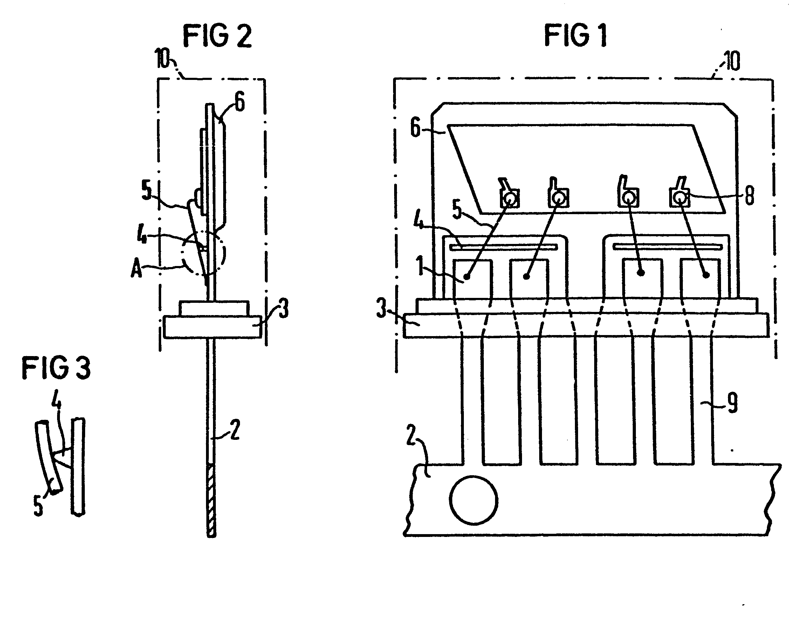

Das OFW-Filter nach Fig. 1 und 2 besitzt einen Systemträger 2, eine Chipwanne 6 und äussere elektrische und mechanische Anschlusselemente 9. Der Systemträger 2 ist mit einem Gehäusesokkel 3 aus thermoplastischem Material umspritzt und im fertigmontierten Zustand in ein strichliniert angedeutetes, becherartiges Gehäuse 10, z.B. aus Kunststoff oder Metall, eingesetzt. Die Kontaktstellen 1 bzw. 8 der äusseren elektrischen Anschlusselemente 9 und der im Detail nicht dargestellten aktiven Bereiche des OFW-Filters sind mittels Drahtbonden mit bogenförmig geführten Drähten 5 überbrückt.

Gemäss Fig. 2 und 3 sind zwischen den Kontaktstellen 1 und 8 etwa 0,05 bis 0,1 mm hohe Stege 4 aus thermoplastischwem Material an den Systemträger angespritzt, durch welche z.B. ein Kurzschluss des Drahtes mit der Chipwanne 6 vermieden wird.

## Patentansprüche

1. Elektrisches Oberflächenwellenfilter mit einer metallischen Chipwanne (6) als Systemträger, mit streifenförmigen, äusseren Anschlusselementen (9), die gegen die Chipwanne elektrisch isoliert sind, mit drahtgebondeten elektrischen Kontakten (1, 8) zwischen den aktiven Bereichen des Oberflächenwellenfilters und den äusseren Anschlusselementen (9), und mit aus thermoplastischem Material gespritztem Gehäuse- und Systemträgersockel (3) mit Isolierplättchen zwischen den äusseren Anschlusselementen (9) und der Chipwanne, dadurch gekennzeichnet, dass die Isolierplättchen einstückig an den Gehäuse- und Systemträgersockel (3) angeformt sind und auf ihren zu den Bonddrähten (5) gekehrten Seitenflächen einstückig angeformte Stege (4) aufweisen, wobei der Gehäuse- und Systemträgersockel (3), die Isolierplättchen und die Stege (4) aus thermoplastischem Material bestehen.

2. Elektronisches Bauteil nach Anspruch 1, dadurch gekennzeichnet, dass die Stege (4) etwa 0,05 bis 0,1 mm hoch sind.

## Claims

1. An electric surface wave filter having a metal chip trough (6) as a system carrier; strip-shaped, outer terminal elements (9) which are electrically insulated from the chip through; wire-bonded electrical contacts (1, 8) between the active zones of the surface wave filter and the outer terminal elements (9); and a base (3) for a housing and the system carrier which is injection-moulded from thermoplastic material, with insulating plates between the outer terminal elements (9) and the chip trough, characterised in that the insulating plates are integrally moulded with the base (3) for the housing and system carrier and on their side surfaces which face towards the bonding wires (5), are provided with integrally moulded ribs (4), the base (3) for the housing and system carrier, the insulating plates and the ribs (4) all consisting of thermoplastic material.

2. An electronic component as claimed in Claim 1, characterised in that the height of the ribs (4) is about 0.05 to 0.1 mm.

**Revendications**

1. Filtre électrique à ondes de surface avec une cuvette métallique (6) pour la puce, servant de support de système, avec des éléments de liaison extérieurs (9) en forme de bandes et isolés électriquement par rapport à la cuvette, avec des contacts électriques (1, 8) reliés par des fils et situés entre les zones actives du filtre à ondes de surface et les éléments de liaison extérieurs (9), et un socle de boîtier et de support de système (3) en matériau thermoplastique injecté, avec des plaquettes isolantes entre les éléments de liaison extérieurs (9) et la cuvette pour la puce, caractérisé par le fait que les plaquettes isolantes sont conformées d'une pièce avec le socle (3) du boîtier et du support de système, et comportent, sur leurs surfaces latérales tournées vers les fils de liaison (5), des barrettes (4) conformées d'une pièce, le socle (3) du boîtier et du support de système, le plaquettes isolantes et les barrettes (4) étant constitués avec un matériau thermoplastique.

2. Composant électronique selon la revendication 1, caractérisé par le fait que les barrettes (4) ont une hauteur d'environ 0,05 à 0,1 mm.

**FIG 2**

**FIG 1**

**FIG 3**

0 071 827